(19)

Europäisches
Patentamt
European
Patent Office
Office européen
des brevets

(11) **EP 4 319 515 A1**

(12) **EUROPEAN PATENT APPLICATION**
published in accordance with Art. 153(4) EPC

(43) Date of publication:
**07.02.2024 Bulletin 2024/06**

(21) Application number: **22796087.9**

(22) Date of filing: **26.04.2022**

(51) International Patent Classification (IPC):
*H05K 5/00* (2006.01)    *H05K 5/03* (2006.01)
*C03C 17/34* (2006.01)    *C03C 17/00* (2006.01)

(52) Cooperative Patent Classification (CPC):
**C03C 17/00; C03C 17/34; H05K 5/00; H05K 5/03**

(86) International application number:
**PCT/KR2022/005910**

(87) International publication number:
**WO 2022/231254 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.04.2021  KR 20210053815**

(71) Applicant: Samsung Electronics Co., Ltd.
**Suwon-si, Gyeonggi-do 16677 (KR)**

(72) Inventors:
• KIM, Sejin
  **Suwon-si, Gyeonggi-do 16677 (KR)**
• JEONG, Jongwan
  **Suwon-si, Gyeonggi-do 16677 (KR)**
• SIN, Wanju
  **Suwon-si, Gyeonggi-do 16677 (KR)**
• LEE, Jinwook
  **Suwon-si, Gyeonggi-do 16677 (KR)**

(74) Representative: **Arnold & Siedsma
Bezuidenhoutseweg 57
2594 AC The Hague (NL)**

(54) **ELECTRONIC DEVICE INCLUDING HOUSING HAVING PROTECTIVE LAYER FORMED THEREON**

(57)    Disclosed is an electronic device which includes a housing having a protective layer formed thereon. The electronic device according to embodiments of the present invention may include a housing which covers at least a part of the outer surface, wherein the housing comprises: a transparent substrate; a multilayer structure formed on the surface of the transparent substrate and comprising multiple layers which are stacked such that the respective adjacent layers have different refractive indexes; and an aluminum oxide layer formed on the multilayer structure. The transparent substrate may comprise a glass material.

FIG. 4

EP 4 319 515 A1

**Description**

**[Technical Field]**

Various embodiments disclosed in the present document relate to an: electronic device, and more particularly to an electronic device having a protective structure for a housing.

**[Background Art]**

A housing for an electronic device, such as a mobile phone, often includes a transparent material, such as glass, to increase consumer desire to purchase and provide aesthetics to users. A printed film may be attached and/or coated to a rear surface of the transparent material to exhibit various optical effects. For example, a coating layer may be formed by depositing a thin film of various materials on the transparent material to exhibit an iridescence.

The housing of the electronic device is exposed to an external environment and may be exposed to risk factors such as UV light, moisture, and salt (e.g., sweat). These various risk factors may cause damage such as poor adhesion, delamination, bubbling, and discoloration of the coating layer, resulting in poor appearance.

To protect the coating layer of the housing, painting or a protective film may be applied. In case of the painting, defects such as paint running off due to poor masking occur, and in case of the protective film, the protective film may be delaminated due to physical damage when exposed to the outside, or the coating layer may be damaged by penetration of moisture and salt through air gaps on an adhesive surface.

**[Disclosure of Invention]**

**[Technical Problem]**

Various embodiments disclosed in the present document may provide an electronic device with improved durability of a coating layer of a housing.

In addition, various embodiments disclosed in the present document may provide a method of manufacturing a protective structure that improves durability of a coating layer of a housing of an electronic device.

**[Solution to Problem]**

The electronic device according to embodiments of the present invention may include a housing which covers at least a part of the outer surface, wherein the housing comprises: a transparent substrate; a multilayer formed on the surface of the transparent substrate and comprising multiple layers which are stacked such that the respective adjacent layers have different refractive indexes; and an aluminum oxide layer formed on the multilayer. The transparent substrate may comprise a glass material. In some embodiments, the aluminum oxide layer may be formed to cover an upper surface and a side surface of the multilayer when a direction in which the multilayer is stacked on the transparent substrate is the upper surface.

In another embodiment, the housing may have a curved surface portion formed on the edge portion thereof to cover a side surface portion of the electronic device, and wherein the aluminum oxide layer is formed to cover the edge portion of the housing.

In some embodiments, the multilayer may be stacked in a manner such that a first layer having a relatively low refractive index and a second layer having a relatively high refractive index are alternately stacked. In some embodiments, the first layer may include a SiOz material. The second layer may include an oxide of at least one of Ti, Nb, Ta, Zr, or La. In another embodiment, the second layer may include a mixture of Ti oxide and La oxide. In still another embodiment, the second layer may include a mixture in which TiOz and $La_2O_3$ are mixed in a weight ratio of 6:4 to 9:1. In some embodiments, a thickness of the aluminum oxide layer may be 100 nm or less. In another embodiment, the housing may include a buffer layer positioned between the transparent substrate and the multilayer.

A method of manufacturing a housing of an electronic device according to another embodiment of the present invention, may include: a pretreatment step of etching and cleaning a rear surface of a transparent substrate; a stacking step of stacking a plurality of layers to form a multilayer such that the respective adjacent layers on a surface of the transparent substrate have different refractive indexes; and an anti-corrosion treatment step of forming an aluminum oxide layer on the multilayer. In some embodiments, the stacking step may include a first deposition step of depositing a material having a relatively low refractive index and a second deposition step of depositing a material having a relatively high refractive index. In some embodiments, in the first deposition step, SiOz may be deposited, and in the second deposition step, at least one oxide of Ti, Nb, Ta, Zr, or La may be deposited.

In some embodiments, the plurality of layers in the stacking step and the aluminum oxide layer in the anti-corrosion treatment step may be formed by a physical vapor deposition, and the stacking step and the anti-corrosion treatment step may be performed within a same deposition reactor. In some embodiments, the deposition reactor may include a plasma generator, and the pretreatment step may be performed by the plasma generator within the same deposition reactor as the deposition step and the anti-corrosion treatment step.

In some embodiments, the method may further include a curing step of stabilizing the multilayer and the aluminum oxide layer after the anti-corrosion treatment step. The curing step may be performed at room temperature for at least 4 hours. In another embodiment, the curing step may be performed at 130 to 150 °C for 2 to 4 hours. In some embodiments, the method may further comprise a buffer layer formation step of depositing a buffer layer on the transparent substrate after the pretreatment step and before the stacking step.

**[Advantageous Effects of Invention]**

With an aluminum oxide layer as a protective coating, an electronic device may be provided with a housing that has improved resistance to salt water corrosion, UV degradation, and scratches.

In addition, according to another embodiment of the present document, a method of manufacturing a housing of an electronic device having the above-described features may be provided.

**[Brief Description of Drawings]**

In connection with the description of the drawings, the same or similar reference numerals may be used for the same or similar constituent elements.

FIG. 1 is a block diagram of an electronic device in a network environment according to various embodiments.
FIG. 2A is a front perspective view illustrating a housing of an electronic device according to embodiments of the present invention.
FIG. 2B is a rear perspective view illustrating a housing of an electronic device according to embodiments of the present invention.
FIG. 3 is an exploded perspective view illustrating a stacked structure of the housing according to an embodiment of the present invention.
FIG. 4 is a cross-sectional view illustrating a cross-section of a deposition layer of the housing of the electronic device according to embodiments of the present invention.
FIG. 5A is a scanning electron micrograph illustrating an aluminum oxide layer according to an embodiment of the present invention.
FIGS. 5B and 5C are scanning electron micrographs illustrating a SiOz protective layer, according to a comparative example.
FIG. 6 is a schematic view illustrating the housing of an electronic device according to some embodiments of the present invention.
FIG. 7 is a flowchart illustrating a method of manufacturing the housing of the electronic device according to other embodiments of the present invention.

**[Mode for the Invention]**

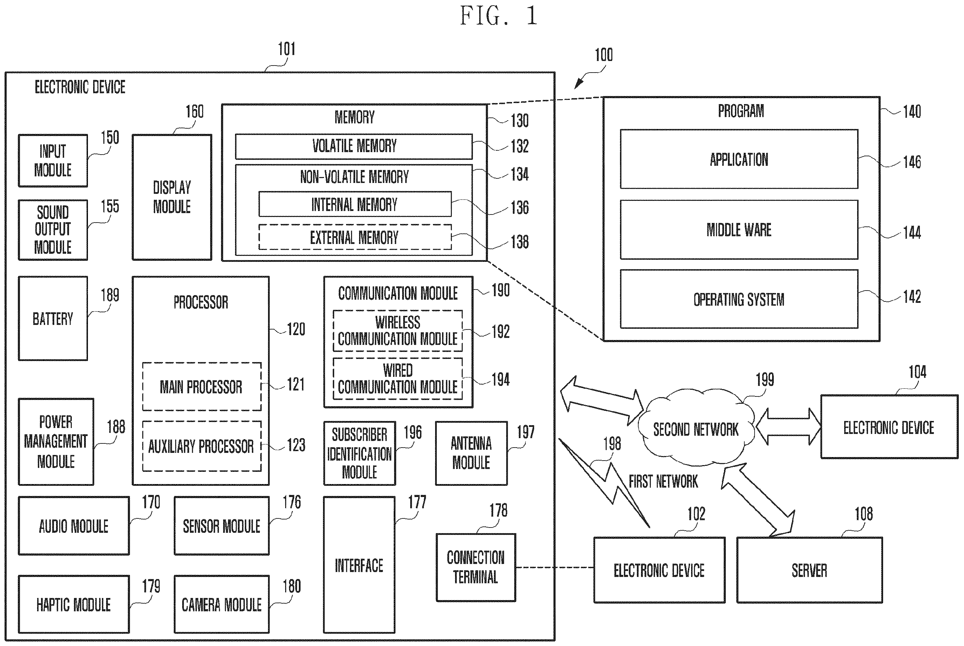

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module(SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input device 150 may receive a command or data to be used by other component (e.g., the processor 120) of the electronic device 101, from the outside (e.g., a user) of the electronic device 101. The input device 150 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a cellular network, the Internet, or a computer network (e.g., LAN or wide area network (WAN))). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., PCB). According to an embodiment, the antenna module 197 may include a plurality of antennas. In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

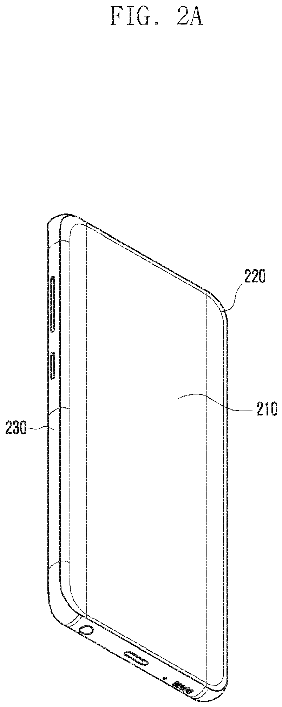

FIG. 2A is a front perspective view illustrating a housing 220 of an electronic device according to embodiments of the present invention.

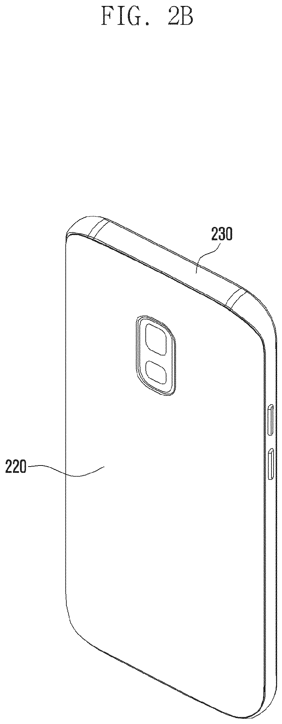

FIG. 2B is a rear perspective view illustrating the housing 220 of an electronic device according to embodiments of the present invention.

With reference to FIGS. 2A and 2B, an electronic device according to embodiments of the present invention may include a display panel 210, a plurality of housings 220, and a frame 230.

The display panel 210 is a part of the display device 160, which may be a component such as a TFT-LCD or OLED for displaying image information to a user. In the electronic device, a direction in which the display panel 210 displays image information may be defined as a front surface, and a direction opposite to the direction of the front surface may be defined as a rear surface, and directions perpendicular to the front surface and the rear surface may be defined as a side surface.

The housing 220 covers at least a portion of front and rear surfaces of the electronic device. In some embodiments, at least a portion of the housing 220 may be transparent. For example, a portion covering a front surface of the display panel 210 may be transparent. To this end, the housing 220 may include a transparent substrate 310. In the housing 220, portions other than the transparent portion may include various layers to enhance aesthetics of the product. The detailed constitution of layers of the housing 220 will be discussed later.

The frame 230 may be disposed to at least partially surround a space between a front surface and a rear surface of the housing 220 of the electronic device, at a side surface of the electronic device. The frame 230 may provide a space for internal constituent elements of the electronic device to be disposed, and may protect the internal constituent elements. In some embodiments, the frame 230 may include a metallic material, and the metallic material of the frame 230 may be electrically connected to an antenna module 197 to function as an antenna.

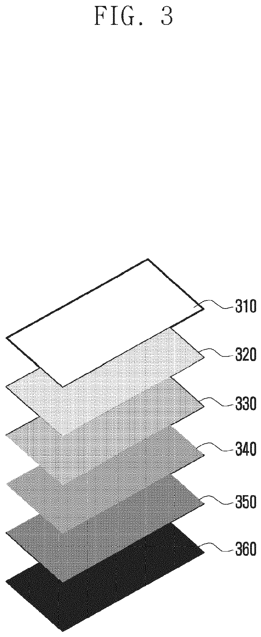

FIG. 3 is an exploded perspective view illustrating a stacked structure of the housing 220 according to an embodiment of the present invention.

With reference to Figure 3, the housing 220 may include the transparent substrate 310, a deposition layer 320, a film layer 330, a molding pattern layer 340, a printing layer 350, and a shielding layer 360.

The transparent substrate 310 may protect the internal constituent elements of the electronic device and serve as a substrate for other layers to be stacked. The transparent substrate 310 may be transparent to allow the user to visibly recognize optical effects caused by other layers stacked on the surface of the transparent substrate 310. In some embodiments, the transparent substrate 310 may be a glass material such as sodalime glass or alkali-aluminosilicate glass. The glass material has a high surface hardness, which has an advantage of being highly aesthetic when polished. In other embodiments, the transparent substrate 310 may be a transparent synthetic resin material, such as polycarbonate or acrylic resin.

The deposition layer 320 may include a multilayer 322 structure that includes a plurality of layers having different optical properties. The deposition layer 320 may have a multilayer 322 structure. The detailed constitution of the deposition layer 320 will be described later. The film layer 330 may be applied on the deposition layer 320 to protect the deposition layer 320.

The molding pattern layer 340 may be a layer embossed or debossed with various patterns to provide aesthetics through decorative effects to the user. In some embodiments, the molding pattern layer 340 may include a UV-cured resin that is shaped by a patterned mold and cured by ultraviolet light to form a pattern. The colored printing layer 350 is a layer with at least one color printed thereon to give the housing 220 a color. In some embodiments, a metal may be deposited on the colored printing layer 350 to give the housing 220 a metallic color. The shielding layer 360 is a layer for preventing the internal constituent elements of the electronic device from being visible to the user, and may include an opaque material such as carbon black, for example.

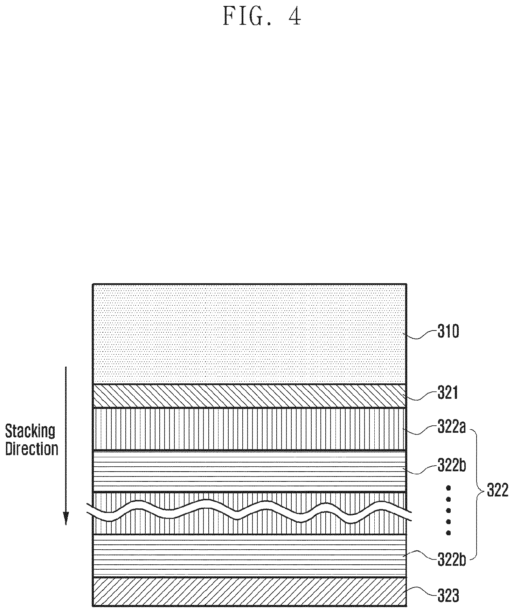

FIG. 4 is a cross-sectional view illustrating a cross-section of the deposition layer 320 of the housing 220 of the electronic device according to embodiments of the present invention.

In FIG. 4, in case of describing that one layer is described as being stacked "on top" of another layer, this may be based on the stacking direction indicated in FIG. 4.

With reference to FIG. 4, the deposition layer 320 of the housing 220 of the electronic device according to embodiments of the present invention may include a buffer layer 321, a multilayer 322, and an aluminum oxide layer 323.

To improve the appearance of the electronic device, the housing 220 may have a structure that exhibits an optical effect, such as an iridescence. The iridescence is a type of structural color, which refers to an exhibition of different colors when viewed from different angles. This iridescence may be exhibited by the multilayer 322 formed on one surface of the housing 220. Specifically, the multilayer 322, which includes a plurality of layers that reflect light, may interfere with different wavelengths of light that are incident at different angles due to the phenomenon of diffraction of light, as shown in Equation 1 below.

[Equation 1]

$$n\lambda = 2d\sin\theta$$

In Equation 1, n is an integer greater than or equal to 1, $\lambda$ is a wavelength of light in a layer where light is reflected, d is a thickness of the layer, and $\theta$ is an angle of incidence of the light. The deposition layer 320 of the housing 220 may include the multilayer 322 having the plurality of layers to have a structure color, such as the iridescence that reflects various colors of light from various angles.

In some embodiments, the multilayer 322 may include a first layer 322a having a relatively low refractive index and a second layer 322b having a relatively high refractive index. The multilayer 322 may have a plurality of layers, with the first layer 322a and the second layer 322b alternately stacked with each other. FIG. 4 illustrates that the first layer 322a is stacked first, followed by the second layer 322b, but this is illustrative, and various stacking sequences that would be recognized by those skilled in the art to accomplish the purpose of the present invention, including that the second layer 322b is stacked first, followed by the first layer 322a, are included within the scope of the present invention.

In case of a plurality of layers with different refractive indexes being deposited, the angle of incidence can be changed as shown in Equation 2 below.

[Equation 2]

$$n_1 \sin\theta_1 = n_2 \sin\theta_2$$

In Equation 2, n1 and n2 are refractive indexes of the first layer 322a and second layer 322b, respectively, and $\theta_1$ and $\theta_2$ are angles of incidence of light at the first layer 322a and second layer 322b, respectively. This structure allows the angle of incidence and reflectivity of light from each layer of the multilayer 322 to be adjusted, and thus the multilayer 322 may cause aesthetic effects using various optical effects.

In some embodiments, a material of the first layer 322a may be a material with a low refractive index, such as SiOz with a refractive index of 1.46. In addition, a material of the second layer 322b may include a material having a high permittivity and a high refractive index, such as an oxide of at least one of Ti, Nb, Ta, Zr, or La. The oxides of the above described metals may have a high permittivity and thus a high refractive index compared to SiOz.

In the deposition of highly refractive materials such as the Ti, Nb, Ta, Zr, or La oxides, dissociation of oxygen ions ($O^{2-}$) in the second layer 322b may occur, depending on a process condition. In this case, a lack of oxygen in the second layer 322b compared to a theoretical composition may result in a defect caused by an oxygen ion vacancy. Positive ions around the oxygen ion vacancy may form an imperfect bond, and this defect may decrease the optical properties (e.g., refractive index) of the second layer 322b and may decrease chemical stability of the second layer 322b, thereby causing an increase in the defect.

For example, in case of Ti oxides, $TiO_2$ and $Ti_3O_5$, they may dissociate from oxygen during the deposition of the second layer 322b, resulting in the second layer to have a composition such as $TiO_x$. In case that the oxygen ion vacancy area is exposed to salt water, such as sweat or seawater, corrosion may occur as Cl- ions dissolved in the salt water react with Ti ions around the vacancy. The corroded layer may cause lifting or delamination of adjacent layers due to a change in volume. The present inventor deposited various oxides as materials for the second layer 322b, and then measured the decrease in refractive index due to the oxygen vacancy and whether the corrosion occurred upon exposure to salt water, the results of which are shown in Table 1.

[Table 1]

| Material name | Theoretical refractive index | Actual refractive index | Corrosion status |
|---|---|---|---|
| $TiO_2$ | 2.34 | 2.1 | Corrosion occurred |
| $Nb_2O_5$ | 2.27 | 2.04 | Corrosion occurred |
| $Ta_2O_5$ | 2.14 | 1.93 | Corrosion occurred |
| $TiO_2+La_2O_3$ mixture | 2.0 | 1.9 | Corrosion occurred |

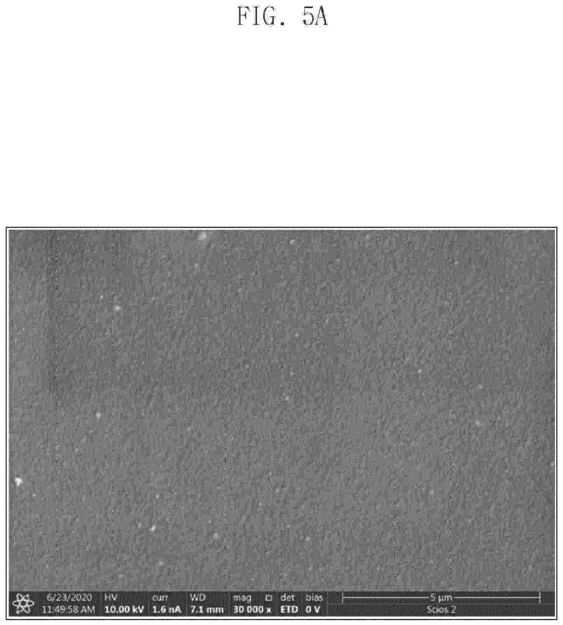

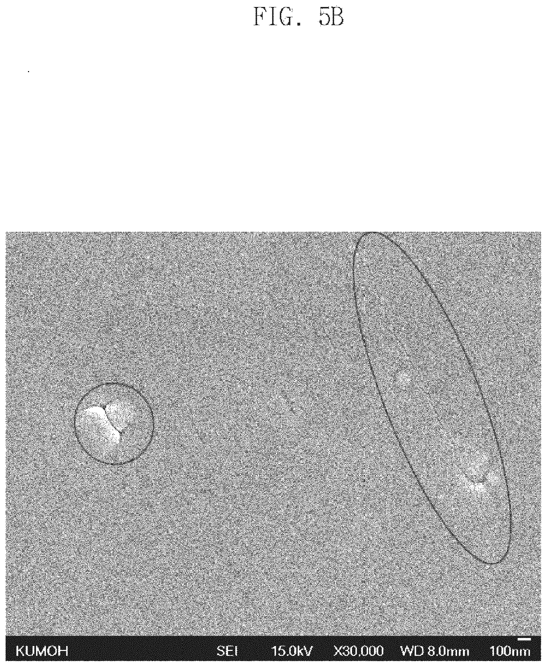

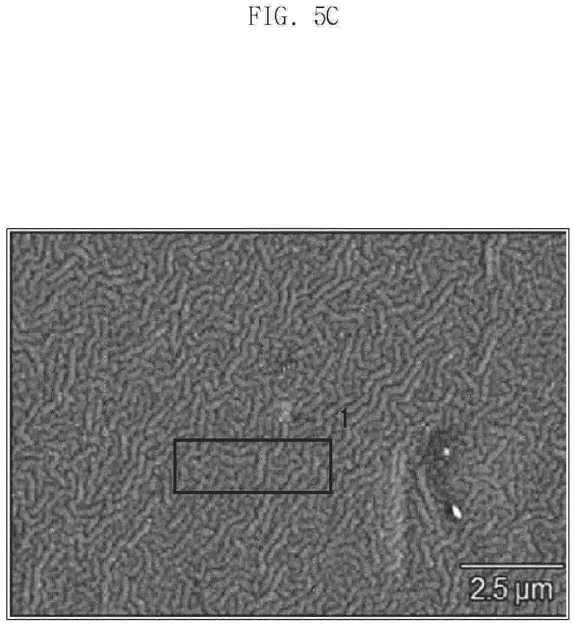

As shown in Table 1, when depositing highly refractive materials such as $TiO_2$, $Nb_2O_5$, $Ta_2O_5$, and $TiO_2+La_2O_3$, defects due to oxygen deficiency occur, which can be confirmed by a decrease in refractive index. To prevent the above described defects, the deposition layer 320 may include a protective layer that protects the multilayer 322. The protective layer may be a SiOz layer similar to the first layer 322a, but preferably an aluminum oxide layer 323, for example, an alumina ($Al_2O_3$) layer. The present inventor tested various materials for protecting the multilayer 322, the results of which are shown in FIGS. 5A, 5B, and 5C.

FIG. 5A is a scanning electron micrograph illustrating a surface of the aluminum oxide layer 323 according to an embodiment of the present invention.

FIGS. 5B and 5C are scanning electron micrographs illustrating a surface of the SiOz protective layer, according to a comparative example.

With reference to FIG. 5A, it can be seen that the aluminum oxide according to an embodiment of the present invention may be deposited with good uniformity and without defects. In contrast, with reference to FIG. 5B, it can be seen that the SiOz protective layer according to a comparative example shows a crater defect, and with reference to FIG. 5C, it can be seen that the SiOz protective layer according to another comparative example shows a wrinkle defect. The wrinkle in FIG. 5C may be caused by an effect of a primer to improve adhesion capability of SiOz.

The crater or wrinkle defects present in SiOz may act as a path for corrosive materials such as salt water to penetrate inside. Therefore, it can be seen that SiOz is undesirable as a material for the protective layer, and that the aluminum oxide layer 323, which may be deposited relatively without defects, is suitable as the protective layer. In addition, the aluminum oxide layer 323 has more than four times the hardness of SiOz, which has an advantage of being highly resistant to other in-process failures such as scratches and dents.

In some embodiments, a thickness of the aluminum oxide layer 323 may be 100 nm or less. The aluminum oxide layer 323 may also exhibit optical effects by refraction, reflection, and diffraction by Equation 1 and Equation 2 described above, which may be different from the optical effects intended by the multilayer 322 structure. Therefore, in case that the thickness of the aluminum oxide layer 323 exceeds 100 nm, an optical interaction with a visible light band (meaning a wavelength of 400 to 700 nm) becomes significant, which may distort or discolor the structural color generated by the multilayer 322, thereby reducing the aesthetics. In addition, in case that the thickness of the aluminum oxide layer 323 exceeds 100 nm, internal stresses in the aluminum oxide may result in poor adhesion capability.

In some embodiments, a thickness of the aluminum oxide layer 323 may be 10 nm or more. A physical vapor deposition (PVD) process may be used for the deposition of the aluminum oxide, and in the PVD, the aluminum oxide layer 323 having a thickness of less than 10 nm may not have a high degree of film uniformity, resulting in defects, which may allow corrosive materials to penetrate the multilayer 322. Improving film quality of the aluminum oxide with a thickness of less than 10 nm may require very expensive and time-consuming processes, such as an atomic layer deposition (ALD), which adversely affects cost and productivity of the electronic device. In addition, in case of using different processes for depositing the aluminum oxide layer 323 and the multilayer 322, additional equipment cost and process lead time may be required.

In some embodiments, the second layer 322b may include a mixture of Ti oxide and La oxide. The Ti oxide and La oxide may have a chemical composition of $TiO_2$ and $La_2O_3$ or similar. In some embodiments, a ratio of the Ti oxide or the La oxide may be 6:4 to 9:1 based on weight. Oxides of metals such as Ti, Nb, Ta, or Zr may dissociate from oxygen upon irradiation with UV light, resulting in defects such as discoloration due to the change in refractive index as described above. The present inventor has confirmed that defects such as those described above do not occur in case of depositing the second layer 322b with the mixture of Ti oxide and La oxide, in contrast to other metal oxides.

In some embodiments, the buffer layer 321 may be positioned between the transparent substrate 310 and the multilayer 322. The buffer layer 321 may improve the adhesion capability of the multilayer 322 to the surface of the transparent substrate 310. In some embodiments, the buffer layer 321 may be an organic compound and/or a silicone-based polymer-based primer.

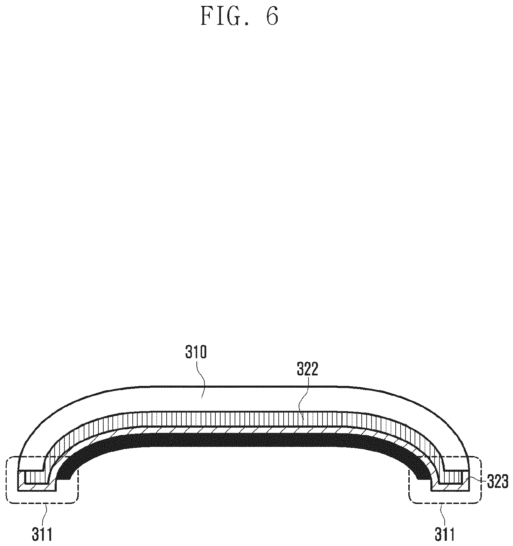

FIG. 6 is a schematic view illustrating the housing 220 of the electronic device according to some embodiments of the present invention.

In FIG. 6, some constituent elements of the housing 220 are omitted for clarity of description. For example, in FIG. 6, the buffer layer 321, the molding pattern layer 340, the colored printing layer 350, and the shielding layer 360 are omitted.

With reference to FIG. 6, the aluminum oxide layer 323 of the housing 220 of the electronic device according to some embodiments of the present invention may cover a side surface of the multilayer 322. The multilayer 322 may be deposited onto a side surface portion of the transparent substrate 310, while extending beyond an edge of one surface of the transparent substrate 310 for an optical effect. In this case, the multilayer 322 may be exposed to an external environment at the side surface portion of the transparent substrate 310.

In case of the film layer 330 of the housing 220, which is attached extending to the side surface portion 311 of the transparent substrate 310, the film layer 330 exposed on the side surface may be physically damaged or lose adhesion and delaminated. Therefore, corrosive materials such as salt water may penetrate the side surface of the multilayer 322, which may cause failures such as delamination or discoloration. Therefore, the aluminum oxide layer 323 on the multilayer 322 may be preferably formed to cover the side surfaces of the multilayer 322.

With reference to FIG. 6, the transparent substrate 310 of the housing 220 may have a curved surface portion formed at an edge portion thereof for an improved grip and aesthetics of the electronic device, and the curved surface portion may cover a portion of the side surface of the electronic device. In this case, the multilayer 322 may extend from the edge portion of the housing 220 to the side surface portion 311 of the transparent substrate 310, and the aluminum oxide layer 323 may preferably be formed to cover the side surface of the multilayer 322 as well as the edge portion of the transparent substrate 310. Therefore, the multilayer 322 may be fully sealed by the aluminum oxide layer 323, thereby fully protecting the multilayer 322 from an external corrosive environment.

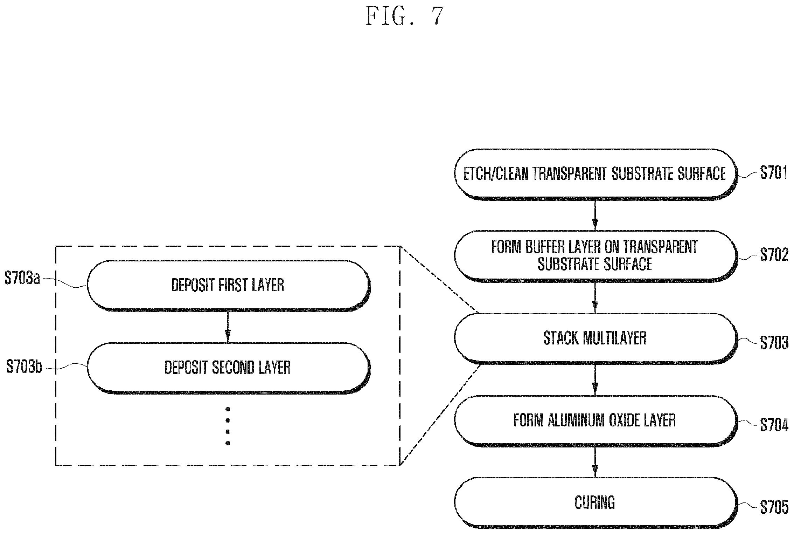

FIG. 7 is a flowchart illustrating a method of manufacturing the housing of the electronic device according to other embodiments of the present invention.

With reference to FIG. 7, a method of manufacturing the housing of the electronic device according to embodiments of the present invention may include a pretreatment step S701, a stacking step S703, and an anti-corrosion treatment step S704.

The pretreatment step S701 may be a step to clean a surface of the transparent substrate 310 by removing foreign substances from the surface by etching. The etch may be a wet etch, but preferably a dry etch. For example, the pretreatment step S701 may employ plasma etching so that the pretreatment step may be performed within a deposition reactor, in common with processes described later. To this end, the deposition reactor used in the manufacturing method of the present invention may include a plasma generator.

The stacking step S703 may be a step of stacking the multilayer 322 described above. In some embodiments, the stacking steps S703 may include a first deposition step S703a for stacking the first layer 322a described above and a second deposition step S703b for stacking the second layer 322b described above. The first and second deposition steps S703a and S703b may be repeated a plurality of times to form a plurality of layers. FIG. 7 illustrates that the first layer is deposited first, followed by the second layer, but this is illustrative, and various stacking sequences that would be recognized by those skilled in the art to accomplish the purpose of the present invention, including that the second layer 322b is stacked first, followed by the first layer 322a, are included within the scope of the present invention.

In the first and second deposition steps S703a and S703b, various deposition methods may be used, such as PVD, chemical vapor deposition (CVD), or ALD, but it may be preferable to use the PVD for the deposition of inorganic materials such as SiOz or TiOz of the present invention. The PVD may include methods such as a sputtering, in which a target containing a source material is hit with plasmatized gas ions to knock the source material off the surface of the target and deposit the source material on the surface of the transparent substrate 310, an e-beam PVD and a pulsed laser deposition (PLD), in which the source material is vaporized with electron beams and laser pulses to deposit the source material on the surface of a deposition target, and a thermal deposition, in which the source material is heated with electrical resistance heat to vaporize and deposit the source material on the surface of a deposition target. A selection of the most suitable individual deposition method may be made in consideration of the characteristics of each raw material and compatibility with other processes.

The anti-corrosion treatment step S704 may be a step of forming the aluminum oxide layer 323 on the multilayer 322 formed in the stacking step S703. The anti-corrosion treatment step S704 may preferably be performed by the same process as the stacking step S703 described above, for example, the PVD.

In some embodiments, a curing step S705 may be performed after the anti-corrosion treatment step S704. The curing step S705 may be a step to stabilize the stacked multilayer 322 and the aluminum oxide layer 323. In case that the curing is not performed, the adhesion between the materials that constitute each layer may not be sufficiently formed, leading to a decrease in an adhesive force therebetween, which may cause problems such as delamination. In some embodiments, the curing may be preferably performed at room temperature for 4 hours or more, but in other embodiments, the curing may be performed for 2 to 4 hours, with a temperature inside the deposition reactor maintained at 130 to 150 °C. In case of maintaining the temperature inside the reactor at 130 to 150 °C, it has an effect of activating movements of atoms and formation of bonds for curing, thus reducing the curing time.

In some embodiments, the method of manufacturing the housing 220 of the electronic device may include a buffer layer formation step S702. The buffer layer 321 may improve adhesion capability of the multilayer to the transparent substrate 310, as described above. In case that the buffer layer 321 includes a silicone-based polymer, it may be possible to deposit the buffer layer 321 onto the surface of the transparent substrate 310 by the PVD, such as in the deposition step described above. In this case, productivity of the housing 220 of the electronic device may be improved by improved compatibility between the respective processes.

Further, the embodiments of the present document disclosed in the present specification and illustrated in the drawings are provided as particular examples for more easily explaining the technical contents according to the embodiments disclosed in the present document and helping understand the embodiments disclosed in the present document, but not intended to limit the scope of the embodiments disclosed the present document. Accordingly, the scope of the various embodiments disclosed the present document should be interpreted to include, in addition to the embodiments disclosed herein, all alterations or modifications derived from the technical ideas of the various embodiments disclosed in the present document.

**Claims**

1. An electronic device comprising:

   a housing covering at least a portion of an outer surface of the electronic device,
   wherein the housing comprises:
   a transparent substrate;
   a multilayer formed on a surface of the transparent substrate and comprising a plurality of layers stacked such that respective adjacent layers have different refractive indexes; and

an aluminum oxide layer formed on the multilayer.

2. The electronic device of claim 1, wherein the aluminum oxide layer is formed to cover an upper surface and a side surface of the multilayer when a direction in which the multilayer is stacked on the transparent substrate is the upper surface.

3. The electronic device of claim 1, wherein the housing has a curved surface portion formed on the edge portion thereof to cover a side surface portion of the electronic device, and
wherein the aluminum oxide layer is formed to cover the edge portion of the housing.

4. The electronic device of claim 1, wherein the multilayer is stacked in a manner such that a first layer having a relatively low refractive index and a second layer having a relatively high refractive index are alternately stacked.

5. The electronic device of claim 4, wherein the first layer comprises a SiOz material.

6. The electronic device of claim 4, wherein the second layer comprises an oxide of at least one of Ti, Nb, Ta, Zr, or La.

7. The electronic device of claim 4, wherein the second layer comprises a mixture of Ti oxide and La oxide.

8. The electronic device of claim 4, wherein the second layer comprises a mixture in which $TiO_2$ and $La_2O_3$ are mixed in a weight ratio of 6:4 to 9:1.

9. A method of manufacturing a housing of an electronic device, comprising:

pretreatment etching and cleaning a rear surface of a transparent substrate;
stacking a plurality of layers to form a multilayer such that the respective adjacent layers on a surface of the transparent substrate have different refractive indexes; and
anti-corrosion treatment forming an aluminum oxide layer on the multilayer.

10. The method of claim 9, wherein the stacking step comprising: first depositing a material having a relatively low refractive index ; and second depositing a material having a relatively high refractive index.

11. The method of claim 9, wherein the plurality of layers in the stacking step and the aluminum oxide layer in the anti-corrosion treatment step are formed by a physical vapor deposition, and
wherein the stacking step and the anti-corrosion treatment step are performed within a same deposition reactor.

12. The method of claim 11, wherein the deposition reactor comprises a plasma generator, and
wherein the pretreatment step is performed by the plasma generator within the same deposition reactor as the deposition step and the anti-corrosion treatment step.

13. The method of claim 9, further comprising a curing step of stabilizing the multilayer and the aluminum oxide layer after the anti-corrosion treatment step.

14. The method of claim 13, wherein the curing step is performed for at least 4 hours at room temperature.

15. The method of claim 13, wherein the curing step is performed at 130 to 150 °C for 2 to 4 hours.

# FIG. 1

ELECTRONIC DEVICE 101

- INPUT MODULE 150
- SOUND OUTPUT MODULE 155
- DISPLAY MODULE 160
- BATTERY 189
- POWER MANAGEMENT MODULE 188
- AUDIO MODULE 170
- HAPTIC MODULE 179

MEMORY 130
- VOLATILE MEMORY 132
- NON-VOLATILE MEMORY 134
  - INTERNAL MEMORY 136
  - EXTERNAL MEMORY 138

PROCESSOR 120
- MAIN PROCESSOR 121
- AUXILIARY PROCESSOR 123

COMMUNICATION MODULE 190
- WIRELESS COMMUNICATION MODULE 192
- WIRED COMMUNICATION MODULE 194

SUBSCRIBER IDENTIFICATION MODULE 196

ANTENNA MODULE 197

SENSOR MODULE 176

CAMERA MODULE 180

INTERFACE 177

CONNECTION TERMINAL 178

PROGRAM 140
- APPLICATION 146
- MIDDLE WARE 144
- OPERATING SYSTEM 142

SECOND NETWORK 199

FIRST NETWORK 198

ELECTRONIC DEVICE 104

ELECTRONIC DEVICE 102

SERVER 108

EP 4 319 515 A1

FIG. 2A

FIG. 2B

FIG. 3

310
320
330
340
350
360

FIG. 4

Stacking
Direction

310

321

322a ⎫
322b ⎪
• ⎪
• ⎬ 322
• ⎪
322b ⎪
323 ⎭

FIG. 5A

FIG. 5B

FIG. 5C

FIG. 6

FIG. 7

EP 4 319 515 A1

ETCH/CLEAN TRANSPARENT SUBSTRATE SURFACE — S701

FORM BUFFER LAYER ON TRANSPARENT SUBSTRATE SURFACE — S702

STACK MULTILAYER — S703

FORM ALUMINUM OXIDE LAYER — S704

CURING — S705

S703a — DEPOSIT FIRST LAYER

S703b — DEPOSIT SECOND LAYER

## INTERNATIONAL SEARCH REPORT

| International application No. |
| --- |
| **PCT/KR2022/005910** |

| A. | CLASSIFICATION OF SUBJECT MATTER |
| --- | --- |

**H05K 5/00**(2006.01)i; **H05K 5/03**(2006.01)i; **C03C 17/34**(2006.01)i; **C03C 17/00**(2006.01)i

According to International Patent Classification (IPC) or to both national classification and IPC

| B. | FIELDS SEARCHED |
| --- | --- |

Minimum documentation searched (classification system followed by classification symbols)

H05K 5/00(2006.01); B05D 5/00(2006.01); B05D 7/02(2006.01); B32B 37/00(2006.01); C23C 14/00(2006.01); C23C 14/54(2006.01); C23C 28/04(2006.01); C23F 11/12(2006.01); C23F 11/18(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 하우징(housing), 투명 기재(transparent substrate), 멀티 레이어(multi layer), 굴절률(refractive index), 알루미늄 산화물 층(aluminum oxide layer)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | KR 10-2014-0021794 A (LEE, Young Hee) 20 February 2014 (2014-02-20)<br>See paragraphs [0061]-[0086] and figure 2. | 1-15 |
| Y | KR 10-1563553 B1 (THIN FILM TECHNOLOGIES CO., LTD.) 27 October 2015 (2015-10-27)<br>See paragraph [0021] and figures 1-6. | 1-15 |
| Y | KR 10-2021-0002894 A (SAMSUNG ELECTRONICS CO., LTD.) 11 January 2021 (2021-01-11)<br>See paragraphs [0083]-[0101] and figures 6-7. | 2-3 |
| Y | WO 2010-008577 A2 (C3 INTERNATIONAL, LLC) 21 January 2010 (2010-01-21)<br>See paragraphs [0137]-[0138]. | 7-8 |
| A | KR 10-2104388 B1 (FLEX-E MATERIALS CO., LTD.) 24 April 2020 (2020-04-24)<br>See paragraphs [0029]-[0093] and figures 1-6. | 1-15 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **10 August 2022** | **10 August 2022** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**
Information on patent family members

International application No.

**PCT/KR2022/005910**

| Patent document cited in search report | | | Publication date (day/month/year) | Patent family member(s) | | | Publication date (day/month/year) |
|---|---|---|---|---|---|---|---|
| KR | 10-2014-0021794 | A | 20 February 2014 | KR | 10-1406845 | B1 | 16 June 2014 |
| KR | 10-1563553 | B1 | 27 October 2015 | | None | | |
| KR | 10-2021-0002894 | A | 11 January 2021 | US | 2022-0110219 | A1 | 07 April 2022 |
| | | | | WO | 2021-002624 | A1 | 07 January 2021 |
| WO | 2010-008577 | A2 | 21 January 2010 | EP | 2315861 | A2 | 04 May 2011 |
| | | | | WO | 2010-008577 | A3 | 22 April 2010 |
| KR | 10-2104388 | B1 | 24 April 2020 | KR | 10-2019-0035049 | A | 03 April 2019 |

Form PCT/ISA/210 (patent family annex) (July 2019)